# EUROPEAN PATENT APPLICATION

(11) **EP 4 783 168 A1**
(43) Date of publication of application: **29.07.2026**
(21) Application number: 26150492.2
(22) Date of filing: 07.01.2026
(51) Int. Cl.: G11C 8/16, G11C 11/419

(54) **DUAL-PORT MEMORY WITH CHARGE SHARING MITIGATION**

(30) Priority: 27.01.2025 US 202519038284
(71) Applicant: Avago Technologies International Sales Pte. Limited, Singapore 768923 (SG)
(72) Inventor: Vijayan, Rejeesh Ammanath, 680596 Thrissur, KL (IN); Gupta, Mohit, 560100 Bangalore, KA (IN); Patel, Palak Jivan, 560068 Bangalore, KA (IN); Kesarwani, Abhishek, 560087 Bangalore, KA (IN); Rai, Dharmendra Kumar, 560100 Bangalore, KA (IN); Katralli, Rajashekhar, 560068 Bangalore, KA (IN); Seikh, Mohammed Rahim Chand, 560068 Bangalore, KA (IN)
(74) Representative: Grünecker Patent- und Rechtsanwälte PartG mbB

(57) **Abstract**

An example memory circuit includes a memory cell coupled to a first row line, a second row line, a first bit line, and a second bit line, the first bit line and the second bit line coupled to a first node of the memory cell, the memory cell configured to store a bit; and a controller including a first write driver coupled to the first bit line and a second write driver coupled to the second bit line, the first write driver configured to, during a first time interval, apply a first voltage to the first bit line in response to a first control signal and a first data signal, the second write driver configured, during the first time interval, to apply the first voltage to the second bit line in response to a second control signal and the first data signal.

## Description

### BACKGROUND

Performing many computations at high speed in a computer can increase demands on the performance of memory. A computer may be a device for storing and processing data. A memory may be a circuit that stores data. Random-access memory (RAM) is a well-known type of memory used in computers. RAM may be memory that can be read and written in any order. To increase performance, a single-port memory can be replaced with dual-port memory. A single-port memory may be a memory that can be accessed using a single bus (e.g., a single bus for address and data). A port of a memory may be an interface to a bus. A bus can include address signals, data signals, control signals, and the like. A dual-port memory may be a memory that has two ports and can be accessed using two different buses.

A useful operation on a dual-port memory is to perform a write operation through one port and a read operation through the other port. To avoid data corruption, a write operation through one port can be skewed with respect to a read operation to the same memory location through the other port. For example, the write and read operations to the same memory location through the two ports can begin at different times, e.g., the write operation is started followed by the read operation or the read operation is started followed by the write operation. There can be some overlap between the write and read operations. Write ability of a memory may be a measure of the speed at which data can be changed at a location in the memory. When performing a write operation through one port, a read operation through the other port (whether beginning before or after the write operation) to the same memory location can degrade write ability.

For example, a location in the memory can store a bit of data. A memory cell may be a circuit that stores a bit of data. A bit may be a state of data, where the state can be logic 0 or logic 1. A write operation can include changing the bit stored by the memory cell from a logic 1 to a logic 0. Such a write operation can include a discharge operation, where a circuit node connected to the memory cell can be discharged from a supply voltage towards electrical ground. The circuit node can exhibit some capacitance such that the change in voltage of the circuit node occurs over some time. However, a read operation to the same memory cell from the other port can include a charge operation, where the same circuit node can be charged to the supply voltage. As such, there can be a condition where the same circuit node experiences a charging operation (from a read) concurrently with a discharging operation (from a write). In either case, the discharging operation of the write can take longer due to charge sharing with the read operation, which can degrade write ability. Managing write ability of a memory can become more challenging as voltage and transistor size decrease.

### SUMMARY

In some embodiments, a memory circuit can include a memory cell coupled to a first row line, a second row line, a first bit line, and a second bit line. The first bit line and the second bit line can be coupled to a first node of the memory cell. The memory cell can be configured to store a bit. The memory circuit can include a controller. The controller can include a first write driver coupled to the first bit line and a second write driver coupled to the second bit line. The first write driver can be configured to, during a first time interval, apply a first voltage to the first bit line in response to a first control signal and a first data signal. The second write driver can be configured to, during the first time interval, apply the first voltage to the second bit line in response to a second control signal and the first data signal.

In some embodiments, an apparatus can include a memory circuit and a first circuit. The memory circuit can include a first port and a second port. The first circuit can be coupled to the memory circuit via the first port and the second port. The first circuit can be configured to supply first signals to the first port to write to a memory cell of the memory circuit and second signals to the second port to read from the memory cell. The memory cell can be coupled to a first bit line and a second bit line. The first bit line and the second bit line can be coupled to a first node of the memory cell. The memory circuit can include a controller. The controller can include a first write driver and a second write driver. The first write driver can be coupled to the first bit line and the second write driver can be coupled to the second bit line. The first write driver can be configured to, during a first time interval, apply a first voltage to the first bit line in response to a first control signal and a first data signal. The second write driver can be configured to, during the first time interval, apply the first voltage to the second bit line in response to a second control signal and the first data signal.

In some embodiments, a method of driving a memory cell in a dual-port memory circuit can include charging a first row line to turn on a first switch of the memory cell that couples a first bit line to a first node of the memory cell. The method can include charging a second row line to turn on a second switch of the memory cell that couples a second bit line to the first node. The method can include applying, by a first write driver during a first time interval, a first voltage to the first bit line in response to a first control signal and a first data signal. The method can include applying, by a second write driver during the first time interval, the first voltage to the second bit line in response to a second control signal and the first data signal.

### BRIEF DESCRIPTION OF THE DRAWINGS

Fig. 1 is a block diagram depicting a memory circuit according to some embodiments.
Fig. 2 is a schematic diagram depicting column circuits and a memory cell according to some embodiments.
Fig. 3A depicts a sequence of operations on a dual-port memory according to some embodiments.
Fig. 3B shows a table describing state of a memory cell in the dual-port memory during the operational sequence of Fig. 3A.
Fig. 3C depicts a sequence of operations on a dual-port memory according to some embodiments.
Fig. 3D shows a table describing state of a memory cell in the dual-port memory during the operational sequence of Fig. 3C.
Fig. 4A is a block diagram depicting a portion of a controller in a memory circuit according to some embodiments.
Fig. 4B is a block diagram depicting another portion of the controller according to some embodiments.
Fig. 4C is a block diagram depicting another portion of the controller according to some embodiments.
Fig. 5A is a block diagram depicting an address collision detection circuit according to some embodiments.
Fig. 5B is a block diagram depicting a portion of the address collision detection circuit of Fig. 5A according to some embodiments.
Fig. 5C is a schematic diagram depicting another portion of the address collision detection circuit of Fig. 5A according to some embodiments.
Fig. 5D is a schematic diagram depicting another portion of the address collision detection circuit of Fig. 5A according to some embodiments.
Figs. 6A-6B show a schematic diagram depicting write drivers coupled to memory cell according to some embodiments.
Fig. 7 is a block diagram depicting a circuit according to some embodiments.
Fig. 8 is a flow diagram depicting a method of driving a memory cell in a dual-port memory circuit according to embodiments.

### DETAILED DESCRIPTION

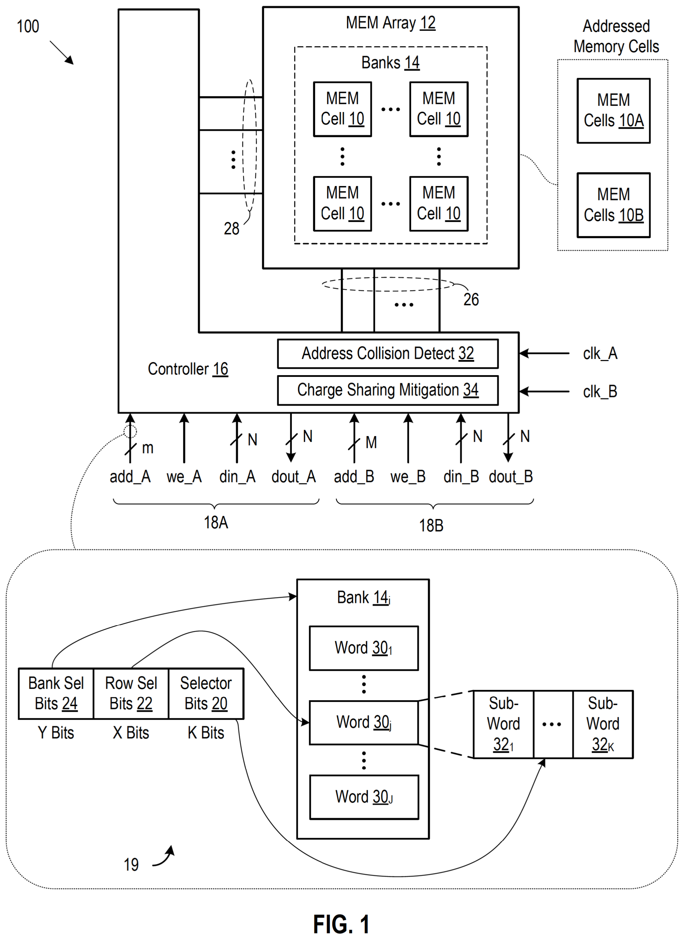

Fig. 1 is a block diagram depicting a memory circuit 100 according to some embodiments. A memory circuit may be a circuit that can store bits of data. Memory circuit 100 can include a memory array 12 (shown as MEM array 12) and a controller 16. A memory array may be a circuit that can store data in a structure of rows and columns of bits. A controller for a memory may be a circuit that supplies signals to and receives signals from a memory array. Memory array 12 can include memory cells 10 arranged in rows and columns. Controller 16 can be coupled to memory array 12 by nodes 26 and nodes 28. A node in a circuit may be a junction where two or more circuit elements are connected. Nodes 26 and 28 can include wires (e.g., conductors) to which circuit elements are connected (e.g., transistors). Each node 28 can include a wire coupled to a row of memory cells 10. Each node 26 can include a wire coupled to a column of memory cells 10. Nodes 28 can be referred to as lines, e.g., row lines or word lines. Nodes 26 can be referred to as lines, e.g., column lines or bit lines. That is, a row line or word line may be a node coupled to a row of memory cells 10. A column line or bit line may be a node coupled to a column of memory cells 10. In some embodiments, memory cells 10 can be organized into banks 14. A bank of memory cells may be a set of the memory cells in a memory array, e.g., a subset of the memory cells. Each bank 14 can include rows and columns of memory cells 10 referred to as local rows and local columns. Local rows of a bank can include all or a portion of nodes 28. Local columns of a bank can include all or a portion of nodes 26.

Controller 16 can include digital logic. Digital logic may be circuit(s) that manipulate digital signals. A digital signal may be a signal discrete in time and amplitude, e.g., a time-ordered sequence of binary codes. Digital logic can include logic gates, as described in some embodiments below. A logic gate may be digital logic that performs a Boolean function, e.g., AND, OR, XOR, NOT, NAND, NOR, and XNOR functions. Logic gates can be combined to create combinational logic (also referred to as combinatorial logic). Combinational logic may be digital logic where the output is a function of the present input only. Opposed to combinational logic, sequential logic may be digital logic where the output depends at least in part on past input (e.g., sequential logic can have state). Controller 16 can include combinational logic and sequential logic, as described in embodiments below. Controller 16 can also include analog circuits. An analog circuit may be a circuit that manipulates analog signals. An analog signal may be a signal continuous in time and amplitude.

Digital logic, including logic gates, can be constructed using transistors, such as field effect transistors (FETs). A FET can be a four-terminal device having gate, source, drain, and substrate terminals. Unless otherwise indicated, the transistors described herein have their substrate terminals coupled to their source terminals and, as such, the substrate terminals are not explicitly shown. FETs can be p-channel FETs or n-channel FETs, where n and p refer to the type of doping in the semiconductor material and the type of majority charge carrier, as is known in the art. Consistent with convention, any p-channel transistors are shown schematically with a bubble on the gate and any n-channel transistors are shown without such a bubble on the gate. There are many types of FETs known in the art. One skilled in the art can select among one or more such FETs based on the description of the examples and embodiments herein. Metal-oxide semiconductor field-effect transistors (MOSFETs) are widely used and well-known FETs. P-channel MOSFETs can be referred to as PMOS transistors and N-channel MOSFETs can be referred to as NMOS transistors. A circuit that includes NMOS transistor(s) and PMOS transistor(s) can be referred to as a complementary metal-oxide semiconductor (CMOS) circuit. Accordingly, some embodiments are described below within the context of NMOS transistors, PMOS transistors, and CMOS circuits.

Controller 16 can include a port 18A and a port 18B. That is, memory circuit 100 can be a dual-port memory. Port 18A can include inputs and outputs for a first bus and port 18B can include inputs and outputs for a second bus. Port 18A can be referred to herein as "port A" and port 18B can be referred to herein as "port B." The suffix "_A" can refer to port A and the suffix "_B" can refer to port B. Port 18A can include an address input (shown as add_A), a write enable (we) input (shown as we_A), a data input (shown as din_A), a data output (shown as dout_A), and a clock input (shown as clk_A). Likewise, port 18B can include an address input (shown as add_B), a write enable input (shown as we_B), a data input (shown as din_B), a data output (shown as dout_B), and a clock input (shown as clk_B). In a general case: each address input add_A and add_B can be an M-bit input, where M is a positive integer; each write enable input we_A and we_B can be a one-bit input; each data input din_A and din_B can be an N-bit input, where N is a positive integer; and each data output dout_A and dout_B can be an N-bit output. The inputs add_A, add_B, we_A, we_B, din_A, and din_B and signals on such inputs can be referred to by the same designation. Likewise, the outputs dout_A and dout_B and the signals on such outputs can be referred to by the same designation. Each clock input clk_A and clk_B can receive a separate clock signal. A clock signal may be a signal that oscillates between voltages representing logic 1 and logic zero (e.g., supply voltage and electrical ground, respectively) at a frequency (e.g., ideally a constant frequency).

As shown in exploded view 19, the address input add_A can include selector bits 20, row select bits 22 (shown as row sel bits 22), and bank select bits 24 (shown as bank sel bits 24). Although not explicitly shown, the address input add_B can include the same bit structure. Selector bits 20 can include K bits, row select bits 22 can include X bits, and bank select bits 24 can include Y bits, where K, X, and Y are positive integers such that K + X + Y = M. In an address, bank select bits 24 can select one of banks 14, e.g., a bank 14ᵢ where i ∈ {1, 2, ..., I} and I is a positive integer number of banks 14. Local rows of a bank can store words 30, e.g., N-bit words. Row select bits 22 can select one of the local rows, e.g., a word 30ⱼ where j ∈ {1, 2, ..., J} and J is a positive integer number of local rows per bank. Each word 30 can be divided into sub-words 32, e.g., sub-words 32₁...32_{K}. Selector bits 20 can select one or more of sub-words 32₁...32_{K}. The selected sub-words 32 include bits stored by a set of memory cells referred to as the addressed memory cells. An address on add_A of port 18A can select memory cells 10A and an address on add_B of port 18B can select memory cells 10B.

In operation, controller 16 can receive an address via the input add_A on port 18A and an address via the input add_B on port 18B. The type of operation can be controlled by the respective we_A and we_B signals. If a write-enable signal indicates write is enabled, then the respective address can be for a write operation on that port. If a write-enable signal indicates write is not enabled, then the respective address can be for a read operation on that port. In some embodiments, each port 18A and 18B can include a separate read enable input (not shown) to enable or not enable a read operation. For purposes of clarity, such read enable inputs are omitted and it is assumed that the we_A and we_B signals can indicate write operations if enabled and read operations if not enabled.

A multi-bit signal, or a range of bits in a multi-bit signal, can be described as signal<u:v>, where u and v are integers such that u ≥ 0 and v > x. A particular bit of a W-bit signal may be referred to as signal[w], where w is an integer bit index and w ∈ {0, 1, ..., W-1}. Signal[0] may be a least significant bit (LSB) and signal[W-1] may be a most significant bit (MSB). An LSB may be a bit with the least weight in a binary value and an MSB may be the bit with the most weight in a binary value. A one-bit signal, such as we_A, or a particular bit of a multi-bit signal, such as add _A[0], can be referred to herein as a logic signal. A multi-bit signal may be a set of logic signals. Two logic signals can be complementary, e.g., one logic signal can be a true version and the other logic signal can be a complement version (e.g., a logical NOT of the true version). Likewise, two sets of logic signals (e.g., two multi-bit signals) can be complementary. A true version of a signal pair can be designated with 't' or 'T' or can have no designation (e.g., BT_A, we_b, etc.). The complement version of the signal pair can be designated with 'c', 'C', 'b', or 'B' (e.g., BB_A, web_b, WDC_A, etc.). A logic signal can be described as enabled or enabling (e.g., making something active) or disabled or disabling (e.g., making something inactive). A logic signal can be active-high or active-low. An active-low signal can be a logic signal where logic 0 indicates enabled and logic 1 indicates disabled. An active-high signal can be a logic signal where logic 1 indicates enabled and logic 0 indicates disabled. While some signals may be described as active-high or active-low for ease of explanation, those skilled in the art will appreciate that the opposite type of logic signal can be used with an appropriate modification of the digital logic.

For a write operation on port 18A (e.g., we_A set to enable), controller 16 can use the address on add_A to select memory cells 10A and use the data on din_A to change the bits stored by memory cells 10A. Likewise, for a write operation on port 18B (e.g., we_B set to enable), controller 16 can use the address on add_B to select memory cells 10B and use the data on din_B to change the bits stored by memory cells 10B. For a read operation on port 18A (e.g., we_A set to disable), controller 16 can use the address on add_A to select memory cells 10A and supply the bits stored by memory cells 10A on dout_A. Likewise, for a read operation on port 18B (e.g., we_B set to disable), controller 16 can use the address on add_B to select memory cells 10B and supply the bits stored by memory cells 10B on dout_B.

In some embodiments, controller 16 can support write-during-read operations. A write-during-read operation may be a condition where each port A and B address common memory cells and one port performs a read and the other port performs a write. In a write-during read operation, memory cells 10A and memory cells 10B can include common memory cells (e.g., a memory cell 10 can be in both memory cells 10A and memory cells 10B). The clock signals for ports A and B can be skewed such that the read and write operations start at different times and one operation starts before the other operation ends (e.g., there is some interval of overlap).

In some embodiments, controller 16 can include address collision detection circuits 32 (shown as address collision detect 32) and charge sharing mitigation circuits 34 (shown as charge sharing mitigation 34). Address collision detect 32 can detect when an address on add_A collides with an address on add_B. An address collision may be the condition during a write-during-read operation, e.g., where the addresses on each port decode to the same word. Detection of address collision can be used to control charge sharing mitigation circuits 34. Charge sharing mitigation 34 can be selectively enabled in write drivers of controller 16 during an address collision condition to mitigate charge sharing between bit lines and improve write ability, as discussed further below.

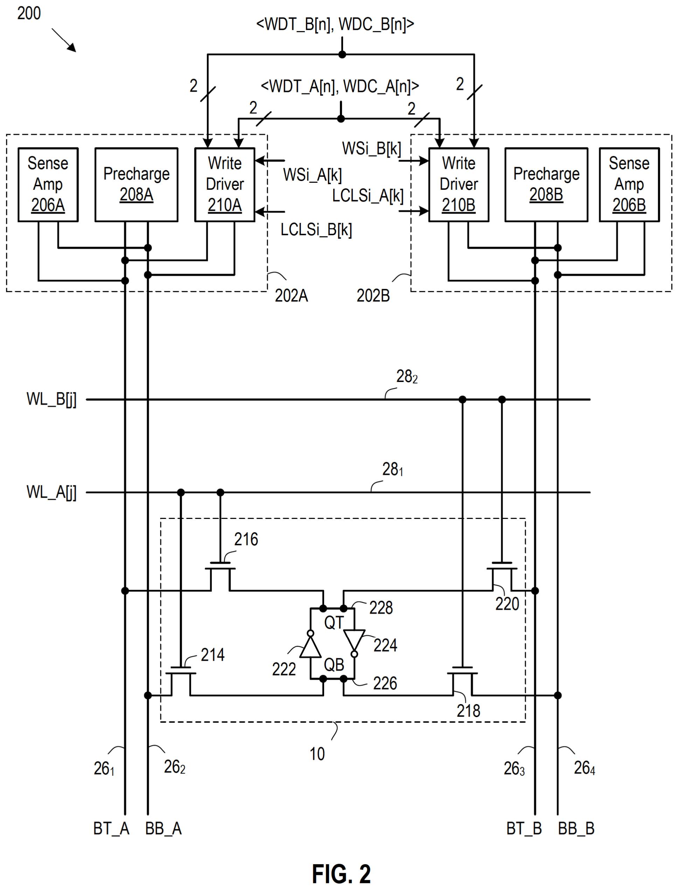

Fig. 2 is a schematic diagram depicting column circuits and a memory cell according to some embodiments. Memory cell 10 can include a cross-coupled pair of inverters 222 and 224, e.g., the output of inverter 222 can be coupled to an input of inverter 224 at a node 228, and an output of inverter 224 can be coupled to an input of inverter 222 at a node 226. Cross-coupled inverters 226 and 228 can store a bit without decay as long as inverters 226 and 228 remain powered. A RAM that includes such memory cells may be referred to as a static random-access memory (SRAM). Node 226 can supply a signal QT (true bit signal) and node 228 can supply a signal QB (complement bit signal).

Memory cell 10 can include NMOS transistors 214, 216, 218, and 220. The source and drain of transistor 214 can be coupled between a bit line 26₂ and node 226. The source and drain of transistor 216 can be coupled between a bit line 26₁ and node 228. The gates of transistors 214 and 216 can be coupled to a word line 28₁. Transistors 214 and 216 can operate as switches and provide a path to cross-coupled inverters 222, 224 for port A. A switch may be a circuit that can couple wires, e.g., a wire of one node to a wire of another node. Turning on a switch may be controlling the switch to electrically connect the wires and turning off a switch may be controlling the switch to electrically isolate the wires. Transistor 214 can be a switch that, when turned on, can electrically connect bit line 26₂ and node 226. Transistor 216 can be a switch that, when turned on, can electrically connect bit line 26₁ and node 228. When turned off, transistors 214 and 216 can electrically isolate bit lines 26₂ and 26₁ from nodes 226 and 228, respectively. Those skilled in the art will appreciate that other types of switches can be used that perform the function of transistors 214 and 216. Bit line 26₁ can be referred to as BT_A (true bit line) and bit line 26₂ can be referred to as BB_A (complement bit line).

The source and drain of transistor 218 can be coupled between a bit line 26₄ and node 226. The source and drain of transistor 220 can be coupled between a bit line 26₃ and node 228. The gates of transistors 218 and 220 can be coupled to a word line 28₂. Transistors 218 and 220 can operate as switches and provide a path to cross-coupled inverters 222, 224 for port B. Transistor 218 can be a switch that can, when turned on, electrically connect bit line 26₄ and node 226. Transistor 220 can be a switch that, when turned on, can electrically connect bit line 26₃ and node 228. When turned off, transistors 218 and 220 can electrically isolate bit lines 26₄ and 26₃ from nodes 226 and 228, respectively. Those skilled in the art will appreciate that other types of switches can be used that perform the function of transistors 218 and 220. Bit line 26₃ can be referred to as BT_B (true bit line) and bit line 26₄ can be referred to as BB_B (complement bit line). Inverters 222 and 228 can be CMOS circuits each having a PMOS transistor and an NMOS transistor. Thus, memory cell 10 can include eight transistors and can be referred to as an 8T memory cell.

Controller 16 can include a column circuit 202A and a column circuit 202B. A column circuit may be a circuit that can supply signals to bit lines in a memory circuit. Column circuit 202A can be coupled to bit lines 26₁ and 26₂. Column circuit 202B can be coupled to bit lines 26₃ and 26₄. Column circuit 202A can include a sense amplifier 206A (shown as sense amp 206A), a precharge circuit 208A (shown as precharge 208A), and a write driver 210A. Column circuit 202B can include a sense amplifier 206B (shown as sense amp 206B), a precharge circuit 208B (shown as precharge 208B), and a write driver 210B. A sense amplifier may be a circuit, such as an analog circuit, which amplifies and detects voltage of a signal, e.g., a voltage difference between nodes 226 and 228 of memory cell 10. Sense amplifier 206A can be coupled to bit lines 26₁ and 26₂ and sense amplifier 206B can be coupled to bit lines 26₃ and 26₄. A precharge circuit may be a circuit that charges capacitance. A bit line in a memory circuit can be coupled to many transistors in parallel such that the parasitic capacitance of the transistors sums to a capacitance of the bit line. A precharge circuit can charge the capacitance of a bit line, e.g., in preparation of sensing the voltage difference between the nodes of the memory cell during a read. Precharge circuit 208A can be coupled to bit lines 26₁ and 26₂ and precharge circuit 208B can be coupled to bit lines 26₃ and 26₄. A write driver may be a circuit that can change the state of a bit stored by a memory cell. Write driver 210A can be coupled to bit lines 26₁ and 26₂ and write driver 210B can be coupled to bit lines 26₃ and 26₄.

Memory cell 10 shown in Fig. 2 can be a memory cell in an ith bank (e.g., bank 14ᵢ), in a jth local row (e.g., a local row storing a word 30ⱼ), and storing a bit of the kth sub-word (e.g., sub-word 32ₖ). Other memory cells 10 in memory array 12 can be configured the same as shown in Fig. 2. Write driver 210A can receive true and complement versions of the nth bits from din_A and din_B, e.g., WDT_A[n] and WDC_A[n] for the nth bit of din_A and WDT_B[n] and WDC_B[n] for the nth bit of din_B. Likewise, write driver 210B can receive WDT_A[n], WDC_A[n], WDT_B[n], and WDC_B[n]. The logic signals WDT_A[n], WDC_A[n], WDT_B[n], and WDC_B[n] can be referred to as data signals to indicate that the signals are derived from din_A and din_B. A data signal in the context of a memory circuit may be a signal that conveys data to be stored in, or stored in, the memory circuit. A first signal can be derived from a second signal when the state of the first signal depends on the state of the second signal.

Write driver 210A can receive a logic signal derived from the kth bit of selector bits 20 on add_A, e.g., WSi_A[k]. Write driver 210B can receive a logic signal derived from the kth bit of selector bits 20 on add_B, e.g., WSi_B[k]. Write driver 210A can receive a logic signal to control charge sharing mitigation, e.g., LCLSi_B[k]. Write driver 210B can receive a logic signal to control charge sharing mitigation, e.g., LCLSi_A[k]. The logic signals WSi_A[k], WSi_B[k], LCLSi_A[k], and LCLSi_B[k] can be referred to as control signals to indicate that the signals control their respective write drivers. A control signal in the context of a memory circuit may be a signal that controls a circuit. The generation of the signals supplied to write drivers 210A and 210B is described below. In addition, write line 28₁ can receive a signal WL _A[j] and write line 28₂ can receive a signal WL _B[j]. The generation of signals WL_A[j] and WL_B[j] is described below.

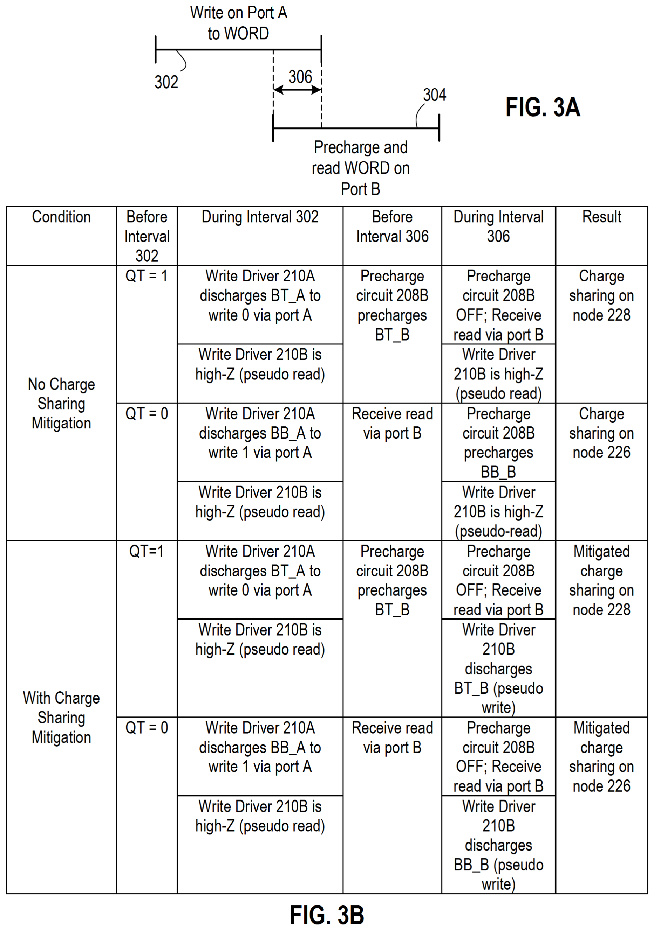

Fig. 3A depicts a sequence of operations on a dual-port memory according to some embodiments. During an interval 302, controller 16 can perform a write operation on port A to a given word (designated WORD). During an interval 304, controller 16 can perform a precharge and read operation on port B of the same word. Interval 302 overlaps interval 304 during an interval 306. Since both port A and port B are addressing the same word, there is an address collision. Intervals 302, 304, and 306 can be referred to as time intervals. A time interval may be a period of time between a start time and an end time.

Fig. 3B shows a table describing state of a memory cell in the dual-port memory during the operational sequence of Fig. 3A. The table in Fig. 3B can be considered in conjunction with Fig. 2. Assume memory cell 10 in Fig. 2 stores a bit of WORD and the write on port A is changing the state of the bit. During interval 302, WL_A[j] can be logic 1. This condition turns on transistor 216 to electrically connect BT_A to node 228 and turns on transistor 214 to electrically connect BB_A to node 226. During interval 304, WL_B[j] can be logic 1. This condition turns on transistor 220 to electrically connect BT_B to node 228 and turns on transistor 218 to electrically connect BB_B to node 226. During interval 306, all transistors 214, 216, 218, and 220 are on, which electrically connects both BT_A and BT_B to node 228 and both BB_A and BB_B to node 226.

The upper half of the table describes the case if there is no charge sharing mitigation (e.g., the case if the techniques described herein are not employed). Consider a case where, before interval 302, memory cell 10 (Fig. 2) can store a logic 1 (e.g., QT = 1). During interval 302, write driver 210A can discharge BT_A to write a logic 0 via port A and write driver 210B can be high impedance. A circuit may discharge a capacitive node (e.g., a bit line) at a first voltage by electrically connecting the capacitive node to a second voltage lower than the first voltage (e.g., the first voltage can be a supply voltage and the second voltage can be electrical ground). Electrically connecting a node to another node at a certain voltage may be referred to as applying the certain voltage to the node or driving the node with the certain voltage. A circuit can be in a high impedance condition when the circuit acts as an impedance between nodes. The operational details of write drivers 210A and 210B are discussed below. The state of a write driver being high impedance can be referred to as a pseudo read. Before interval 306, precharge circuit 208B can charge BT_B before sense amplifier 206B is activated to perform the read. A circuit may charge a capacitive node (e.g., a bit line) by electrically connecting the capacitive node to a voltage (e.g., a supply voltage). During interval 306 (the overlap), precharge circuit 208B can be off and controller 16 can receive the read via port B. This results in charge sharing on node 228, since BT_A is discharging and BT_B is charging, while both being electrically connected to node 228. This can cause the voltage on node 228 to bounce (e.g., temporarily increase), degrading write ability. During interval 306, write driver 210B can be pseudo-read.

In a similar case, before interval 302, memory cell 10 (Fig. 2) can store a logic 0 (e.g., QB = 1). During interval 302, write driver 210A can discharge BB_A to write a logic 1 via port A and write driver 210B can be high impedance (pseudo read). Before interval 306, controller 16 can receive the read via port B. During interval 306 (the overlap), precharge circuit 208B can charge BB_B before sense amplifier 206B is activated to perform the read. This results in charge sharing on node 226, since BB_A is discharging and BB_B is charging, while both being electrically connected to node 226. This can cause the voltage on node 226 to bounce, degrading write ability. During interval 306, write driver 210B can be pseudo-read.

The lower half of the table describes the case where charge sharing mitigation is active according to some embodiments. Consider a case where, before interval 302, memory cell 10 (Fig. 2) can store a logic 1 (e.g., QT = 1). During interval 302, write driver 210A can discharge BT_A to write a logic 0 via port A. Charge sharing mitigation can control write driver 210B to be high impedance (pseudo read). Before interval 306, precharge circuit 208B can be active (e.g., charging). However, BT_B can remain discharged via the pseudo write operation of write driver 310B. During interval 306 (the overlap), precharge circuit 208B can be off and a read can be received via port B. Write driver 210B can be active (e.g., outside of a write operation on port B), which is referred to as a pseudo write. BT_B can remain discharged via the pseudo write operation of write driver 310B. Write driver 310B can sink the current supplied by precharge circuit 208B. This results in charge sharing mitigation on node 228, since BT_A and BT_B are both discharging. This can improve write ability. The read operation is not affected, since memory cell 10 now stores logic 0 and BT_B can be discharged during the read to read the logic 0.

In a similar case, before interval 302, memory cell 10 (Fig. 2) can store a logic 0 (e.g., QT = 0). During interval 302, write driver 210A can discharge BB_A to write a logic 1 via port A. Charge sharing mitigation can control write driver 210B to discharge BB_B in a pseudo write operation. Before interval 306, controller 16 can receive the read via port B. During interval 306 (the overlap), precharge circuit 208B can be off and a read can be received via port B. Write driver 210B can be active in pseudo write. BB_B can remain discharged via the pseudo write operation of write driver 310B. Write driver 310B can sink the current supplied by precharge circuit 208B. This results in charge sharing mitigation on node 226, since BB_A and BB_B are both discharging. This can improve write ability. The read operation is not affected, since memory cell 10 now stores logic 1 and BB_B can be discharged during the read to read the logic 1.

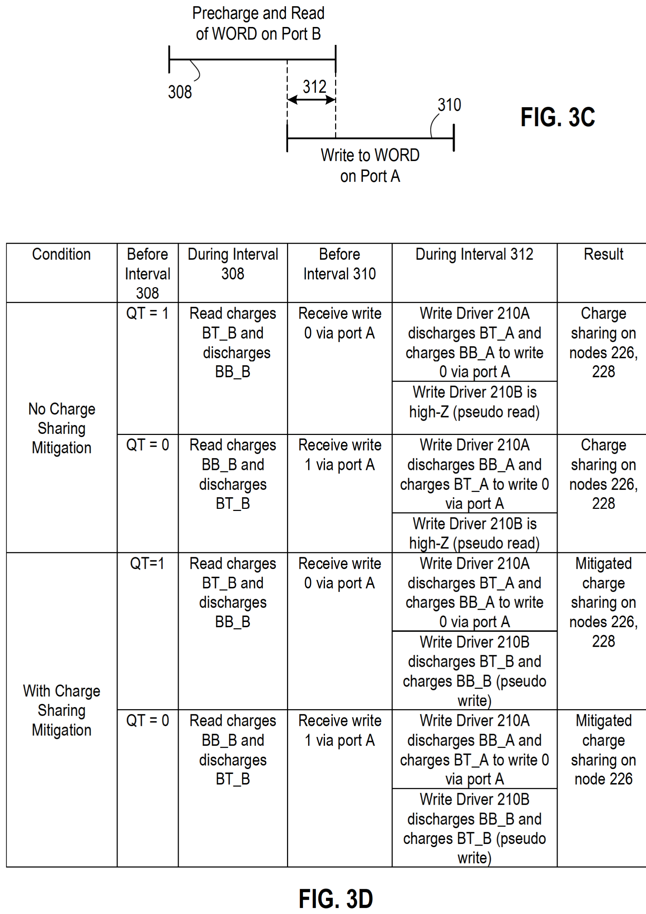

Fig. 3C depicts a sequence of operations on a dual-port memory according to some embodiments. During an interval 308, controller 16 can perform a precharge and read operation on port B to a given word (designated WORD). During an interval 310, controller 16 can perform write operation to the same word on port A. Interval 312 overlaps interval 308 during an interval 310. Since both port A and port B are addressing the same word, there is an address collision. Intervals 308, 310, and 312 can be time intervals.

Fig. 3D shows a table describing state of a memory cell in the dual-port memory during the operational sequence of Fig. 3C. The table in Fig. 3D can be considered in conjunction with Fig. 2. Assume memory cell 10 in Fig. 2 stores a bit of WORD and the write on port A is changing the state of the bit. During interval 308, WL_B[j] can be logic 1. This condition turns on transistor 220 to electrically connect BT_B to node 228 and turns on transistor 218 to electrically connect BB_B to node 226. During interval 310, WL_B[j] can be logic 1. This condition turns on transistor 216 to electrically connect BT_A to node 228 and turns on transistor 214 to electrically connect BB_A to node 226. During interval 312, all transistors 214, 216, 218, and 220 are on, which electrically connects both BT_A and BT_B to node 228 and both BB_A and BB_B to node 226.

The upper half of the table describes the case where there is no charge sharing mitigation (e.g., the case if the techniques described herein are not employed). Consider a case where, before interval 308, memory cell 10 (Fig. 2) can store a logic 1 (e.g., QT = 1). During interval 308, precharge circuit 208B can perform a precharge operation and sense amplifier 206B can read from memory cell 10. The read can result in charging of BT_B, since node 228 is at supply voltage representing logic 1, and discharging of BB_B, since node 226 is at electrical ground representing logic 0. Before interval 310, controller 16 can receive the write via port A. During interval 312 (the overlap), write driver 210A can discharge BT_A and charge BB_A to write a logic 0 via port A. Write driver 310B can be high impedance (pseudo read). This results in charge sharing on nodes 226, 228. BT_A is discharging and BT_B is charged while both being electrically connected to node 228. BB_A is charging and BB_B is discharged while both being electrically connected to node 226. This can affect the voltages on nodes 226 and 228 during the write, which can degrade write ability.

In a similar case, before interval 308, memory cell 10 (Fig. 2) can store a logic 0 (e.g., QT = 0). During interval 308, precharge circuit 208B can perform a precharge operation and sense amplifier 206B can read from memory cell 10. The read can result in charging of BB_B, since node 226 is at supply voltage representing logic 1, and discharging of BT_B, since node 228 is at electrical ground representing logic 0. Before interval 310, controller 16 can receive the write via port A. During interval 312 (the overlap), write driver 210A can discharge BB_A and charge BT_A to write a logic 0 via port A. Write driver 310B can be high impedance (pseudo read). This results in charge sharing on nodes 226 and 228. BB_A is discharging and BB_B is charged while both being electrically connected to node 226. BT_A is charging and BT_B is discharged while both being electrically connected to node 228. This can affect the voltages on nodes 226 and 228 during the write, which can degrade write ability.

The lower half of the table describes the case where charge sharing mitigation is active according to some embodiments. Consider a case where, before interval 308, memory cell 10 (Fig. 2) can store a logic 1 (e.g., QT = 1). During interval 308, precharge circuit 208B can perform a precharge operation and sense amplifier 206B can read from memory cell 10. The read can result in charging of BT_B, since node 228 is at supply voltage representing logic 1, and discharging of BB_B, since node 226 is at electrical ground representing logic 0. Before interval 310, controller 16 can receive the write via port A. During interval 312 (the overlap), write driver 210A can discharge BT_A and charge BT_B to write a logic 0 via port A. Concurrently, charge sharing mitigation can control write driver 210B to discharge BT_B and charge BB_B (pseudo write). This results in charge sharing mitigation on node 228, since BT_A and BT_B are both discharging, and charge sharing mitigation on node 226, since BB_A and BB_B are both charging. This can improve write ability.

In a similar case, before interval 308, memory cell 10 (Fig. 2) can store a logic 0 (e.g., QT = 0). During interval 308, precharge circuit 208B can perform a precharge operation and sense amplifier 206B can read from memory cell 10. The read can result in charging of BB_B, since node 226 is at supply voltage representing logic 1, and discharging of BT_B, since node 228 is at electrical ground representing logic 0. Before interval 310, controller 16 can receive the write via port A. During interval 312 (the overlap), write driver 210A can discharge BB_A and charge BT_A to write a logic 0 via port A. Concurrently, charge sharing mitigation can control write driver 210B to discharge BB_B and charge BT_B (pseudo write). This results in charge sharing mitigation on node 226, since BB_A and BB_B are both discharging, and charge sharing mitigation on node 228, since BT_A and BT_B are both charging. This can improve write ability.

Referring to Fig. 2, the logic signal WSi_A[k] can be set to enable or disable based on a corresponding bit in selector bits 20 in add_A for port A. For a write operation on port A, WSi_A[k] can be enabled when memory cell 10 is addressed (e.g., part of memory cells 10A). For a read operation on port A, WSi_A[k] can be disabled. Likewise, the logic signal WSi_B[k] can be set to enable or disable based on a corresponding bit in selector bits 20 in add_B for port B. For a write operation on port B, WSi_B[k] can be enabled when memory cell 10 is addressed (e.g., part of memory cells 10B). For a read operation on port B, WSi_B[k] can be disabled.

The logic signal LCLSi_A[k] can be set to enable or disable charge sharing mitigation, respectively. For a write operation on port A that addresses memory cell 10, LCLSi_A[k] can be disabled, since write driver 210A is being used to perform an actual write. For a read operation on port A that addresses memory cell 10, LCLSi_A[k] can be selectively enabled depending on whether there is an address collision. If there is no address collision, LCLSi_A[k] can be disabled during the read operation on port A. If there is an address collision, LCLSi_A[k] can be enabled such that write driver 210A performs a pseudo write.

Likewise, the logic signal LCLSi_B[k] can be set to enable or disable to enable or disable charge sharing mitigation, respectively. For a write operation on port B that addresses memory cell 10, LCLSi_B[k] can be disabled, since write driver 210B is being used to perform an actual write. For a read operation on port B that addresses memory cell 10, LCLSi_B[k] can be selectively enabled depending on whether there is an address collision. If there is no address collision, LCLSi_B[k] can be disabled during the read operation on port B. If there is an address collision, LCLSi_B[k] can be enabled such that write driver 210B performs a pseudo write.

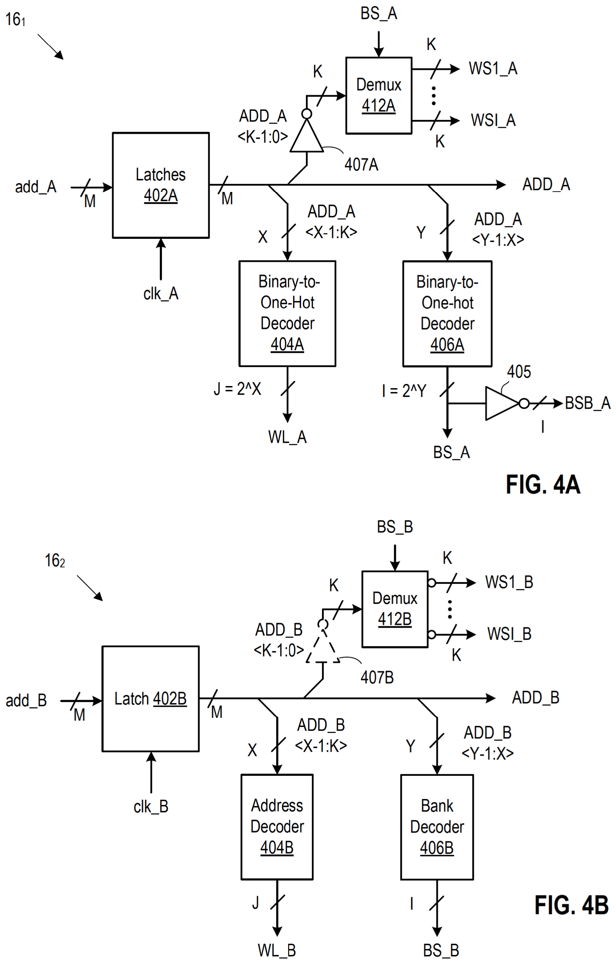

Fig. 4A is a block diagram depicting a portion 16₁ of controller 16 according to some embodiments. Controller 16 can include latches 402A, a binary-to-one-hot decoder 404A, a binary-to-one-hot decoder 406A, and a demultiplexer 412A (shown as demux 412A). A latch may be sequential logic that can have two stable states, e.g., can store a bit of data. A latch can be level-triggered, e.g., its output follows its input while a control input is enabled and the output remains stable while the control input is disabled). Latches 402A can store bits of add_A on port 18A. The clock signal clk_A can be the control input for latches 402A. While latches are described in the embodiments as storage elements for bits, those skilled in the art will appreciate that other types of sequential logic circuits can be used to store bits (e.g., flip-flops that are edge-triggered). Latches 402A can supply an M-bit output referred to as ADD_A.

A binary-to-one-hot decoder may be a circuit that converts a binary input into a one-hot output. One-hot encoding may be a group of bits among which the legal combinations of values are only those with a single logic 1 and all others logic 0. The input of binary-to-one-hot decoder 404A can receive ADD_A<X-1:K> of ADD_A (e.g., row select bits 22). Binary-to-one-hot decoder 404A can include combinational logic that generates a one-hot output referred to as WL_A. The output WL_A can include J = 2^{X} bits. If the logic 1 bit of WL_A is at WL_A[j], the binary value of row select bits 22 selects the jth row of rows 1 through J.

The input of binary-to-one-hot decoder 406A can receive ADD<Y-1:X> of ADD_A (e.g., bank select bits 24). Binaray-to-one-hot decoder 406A can include combinational logic that generates a one-hot output referred to as BS_A. The output BS_A can include I = 2^{Y} bits. If the logic 1 of BS_A is at BS_A[i], the binary value of bank select bits 24 selects the ith bank of banks 1 through I. Controller 16 can include an inverter 405 where the input is BS_A and the output is BSB_A. An inverter may be digital logic that implements logical NOT. Due to the logical negation of a one-hot input, BSB_A can be a one-cold signal. One-cold encoding may be a group of bits among which the legal combinations of values are only those with a single logic 0 and all others logic 1.

A demultiplexer may be a circuit that couples an input to a selected output of a plurality of outputs. An input of demultiplexer 412A can receive ADD_A<K-1:0> (e.g., selector bits 20). Another input of demultiplexer 412A can receive BS_A. Demultiplexer 412A can include outputs WS1_A, WS2_A, ..., WSI_A (where I is the number of banks). Each output WSi_A can be a K-bit output. Demultiplexer 412A can use BS_A to control the coupling of the input to a selected one of the outputs. For BS_A[i] being the logic 1 of the one-hot signal, demultiplexer 412A can select the output WSi_A to receive the input ADD_A<K-1:0>. For all other non-selected outputs, demultiplexer 412A can set the bits to disable writing, e.g., set to logic 1. The signals WS1_A... WSI_A can control write drivers to perform write operations on port A. In the embodiments described, a logic signal WSi_A[k] can enable writing when logic 0. Thus, the signals WS1_A...WSI_A can be active low. In some embodiments, selector bits 20 may be active high. In such embodiments, controller 16 can include an inverter 407A to invert ADD_A<K-1:0> at the input of demultiplexer 412A.

Fig. 4B is a block diagram depicting a portion 16₂ of controller 16 according to some embodiments. Controller 16 can include latches 402B, a binary-to-one-hot decoder 404B, a binary-to-one-hot decoder 406B, and a demultiplexer 412B (shown as demux 412B). Latches 402B can store bits of add_B on port 18B. The clock signal clk_B can be the control input for latches 402B. Latches 402B can supply an M-bit output referred to as ADD_B.

The input of binary-to-one-hot decoder 404B can receive ADD_B<X-1:K> of ADD_B (e.g., row select bits 22). Binary-to-one-hot decoder 404B can include combinational logic that generates a one-hot output referred to as WL_B. The output WL_B can include J bits. If the logic 1 bit of WL_B is at WL_B[j], the binary value of row select bits 22 selects the jth row of rows 1 through J.

The input of binary-to-one-hot decoder 406B can receive ADD<Y-1:X> of ADD_B (e.g., bank select bits 24). Binaray-to-one-hot decoder 406B can include combinational logic that generates a one-hot output referred to as BS_B. The output BS_B can include I bits. If the logic 1 of BS_B is at BS_B[i], the binary value of bank select bits 24 selects the ith bank of banks 1 through I.

An input of demultiplexer 412B can receive ADD_B<K-1:0> (e.g., selector bits 20). Another input of demultiplexer 412B can receive BS_A. Demultiplexer 412B can include outputs WS1_B, WS2_B, ..., WSI_B (where I is the number of banks). Each output WSi_B can be a K-bit output. Demultiplexer 412B can use BS_B to control the coupling of the input to a selected one of the outputs. For BS_B[i] being the logic 1 of the one-hot signal, demultiplexer 412B can select the output WSi_B to receive the input ADD _B<K-1:0>. For all other non-selected outputs, demultiplexer 412B can set the bits to disable writing, e.g., set to logic 1. The signals WS1 B...WSI B can control write drivers to perform write operations on port B. In the embodiments described, a logic signal WSi_B[k] can enable writing when logic 0. Thus, the signals WS1_B...WSI_B can be active low. In some embodiments, selector bits 20 may be active high. In such embodiments, controller 16 can include an inverter 407B to invert ADD_B<K-1:0> at the input of demultiplexer 412B.

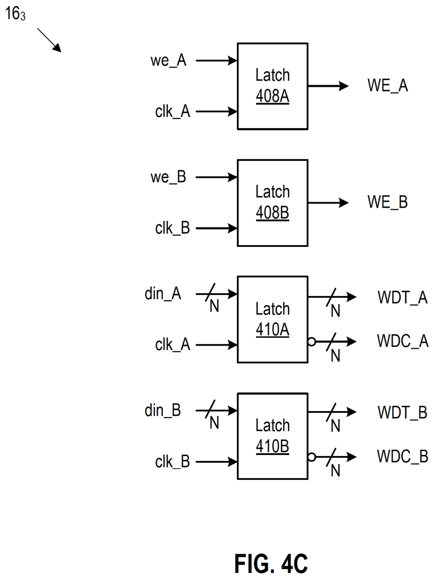

Fig. 4C is a block diagram depicting a portion 16₃ of controller 16 according to some embodiments. Controller 16 can include latches 408A, 408B, 410A, and 410B. The inputs to latch 408A can be we_A and clk_A. The output of latch 408A can be WE_A. The inputs to latch 408B can be we_B and clk_B. The output of latch 408B can be WE_B. In some embodiments, WE_A and WE_B can be active low, meaning write enabled is logic 0 and write disabled (read enabled) is logic 1. In case we_A and we_B are active high, WE_A and WE_B can be output from complement outputs of latches 408A and 408B instead of true outputs. The inputs to latch 410A can be din_A and clk_A. The true output of latch 410A can be WDT_A and the complement output of latch 410A can be WDC_A (each of which is an N-bit signal). The inputs to latch 410B can be din_B and clk_B. The true output of latch 410B can be WDT_B and the complement output of latch 410B can be WDC_B (each of which is an N0bit signal).

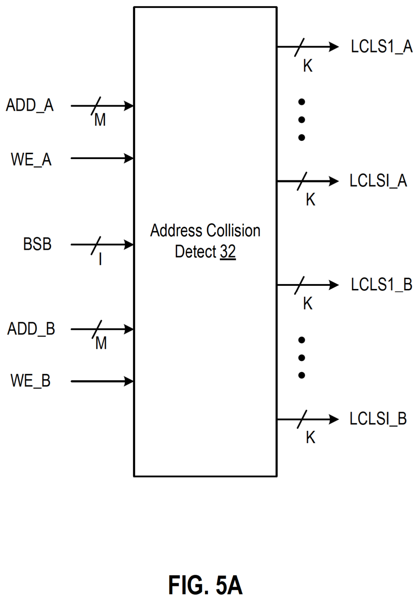

Fig. 5A is a block diagram depicting address collision detection circuit 32 according to some embodiments. Inputs to address collision detect 32 can be ADD_A (from latch 402A), WE_A (from latch 408A), ADD_B (from latch 402B), WE_B (from latch 408B), and BSB_A (from inverter 405). Address collision detect 32 can include combinational logic that provides outputs LCLS1_A...LCLSI_A and LCLS1_B...LCLSI_B, where each is a K-bit output. The K-bit signal LCLSi_A can provide charge mitigation control for an ith bank.

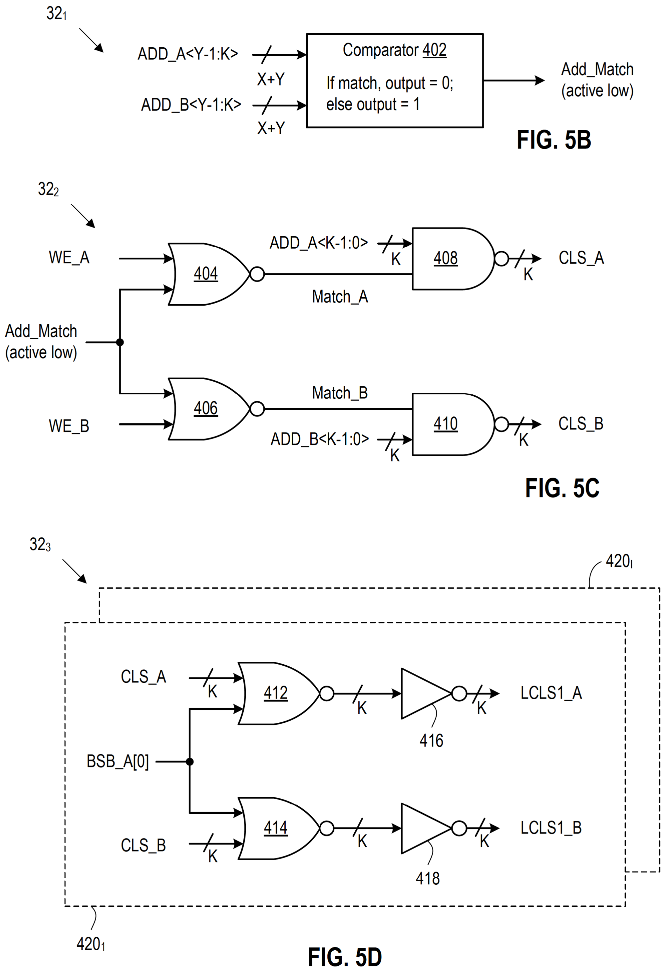

Fig. 5B is a block diagram depicting a portion 32₁ of address collision detection circuit 32 according to some embodiments. Address collision detection circuit 32 can include a comparator 402. A comparator may be a circuit that compares inputs and generates an resulting output of the comparison. Inputs of comparator 402 can include ADD_A<Y-1:K> and ADD_B<Y-1:K> (e.g., bank select bits 24 and row select bits 22 of each address). Comparator 402 can include combinational logic that compares ADD_A<Y-1:K> and ADD_B<Y-1:K> to generate an output Add_Match. In some embodiments, Add_Match can be active low. Thus, Add_match can be logic 0 when ADD_A<Y-1:K> and ADD_B<Y-1:K> match and logic 1 when ADD_A<Y-1:K> and ADD_B<Y-1:K> do not match. A match between ADD_A<Y-1:K> and ADD_B<Y-1:K> indicates that each port A and B is addressing the same word (e.g., an address collision).

Fig. 5C is a schematic diagram depicting a portion 32₂ of address collision detection circuit 32 according to some embodiments. Address collision detection circuit 32 can include a NOR gate 404, a NOR gate 406, a NAND gate 408, and a NAND gate 410. A NOR gate may be digital logic that performs a logical NOR. A NAND gate may be digital logic that performs a logical NAND. Inputs of NOR gate 404 can receive WE_A and Add_Match. Inputs of NOR gate 406 can receive WE_B and Add_Match. An output of NOR gate 404 can provide a logic signal Match_A, and an output of NOR gaste 406 can provide a logic signal Match_B. Inputs of NAND date 408 can receive ADD_A<K-1:0> and Match_A. An output of NAND gate 408 can provide a K-bit signal CLS_A. Inputs of NAND gate 410 can receive ADD_B<K-1:0> and Match_B. An output of NAND gate 410 can provide a K-bit signal CLS_B.

The combinational logic shown in Fig. 5C can generate CLS_A by implementing the Boolean function: NOT(ADD_A<K-1:0> AND NOT(WE_A OR Add_Match)). The combinational logic shown in Fig. 5C can generate CLS_B by implementing the Boolean function: NOT(ADD_B<K-1:0> AND NOT(WE_B OR Add_Match)). The output CLS_A can be understood with respect to the following table:

**TABLE 1 - CLS A**

| WE_A | Add Match | Match_A | CLS_A |
|---|---|---|---|
| 0 (write) | 0 (collision) | 1 (charge mitigation enabled) | NOT(ADD_A<K-1:0>) |
| 1 (read) | 0 (collision) | 0 (charge mitigation disabled) | 11...1 |
| 0 (write) | 1 (no collision) | 0 (charge mitigation disabled) | 11...1 |
| 1 (read) | 1 (no collision) | 0 (charge mitigation disabled) | 11...1 |

The output CLS_B can be understood with respect to the following table:

**TABLE 2- CLS_B**

| WE_B | Add Match | Match B | CLS_B |
|---|---|---|---|
| 0 (read) | 0 (collision) | 1 (charge mitigation enabled) | NOT(ADD B<K-1:0>) |
| 1 (write) | 0 (collision) | 0 (charge mitigation disabled) | 11...1 |
| 0 (read) | 1 (no collision) | 0 (charge mitigation disabled) | 11...1 |
| 1 (write) | 1 (no collision) | 0 (charge mitigation disabled) | 11...1 |

Fig. 5D is a schematic diagram depicting a portion 32₃ of address collision detection circuit 32 according to some embodiments. Address collision detection circuit 32 can include combinational logic 420₁...420_{I}, each corresponding to a respective bank 1...I. Each combinational logic 420ᵢ can include a NOR gate 412, a NOR gate 414, an inverter 416, and an inverter 418. Inputs of NOR gate 412 can receive CLS_A and BSB_A[i]. Inputs of NOR gate 414 can receive CLS_B and BSB_A[i]. The K-bit output of NOR gate 412 can be inverted by inverter 416 to provide LCLSi_A. The K-bit output of NOR gate 414 can be inverted by inverter 418 to provide LCLSi_B. The outputs LCLSi_A and LCLSi_B can be understood with respect to the following table:

**TABLE 3 - LCLSi A and LCLSi_B**

| BSB_A[i] | LCLSi_A | LCLSi_B |
|---|---|---|
| 0 (ith bank selected) | CLS_A | CLS_B |
| 1 (ith bank unselected) | 11...1 | 11...1 |

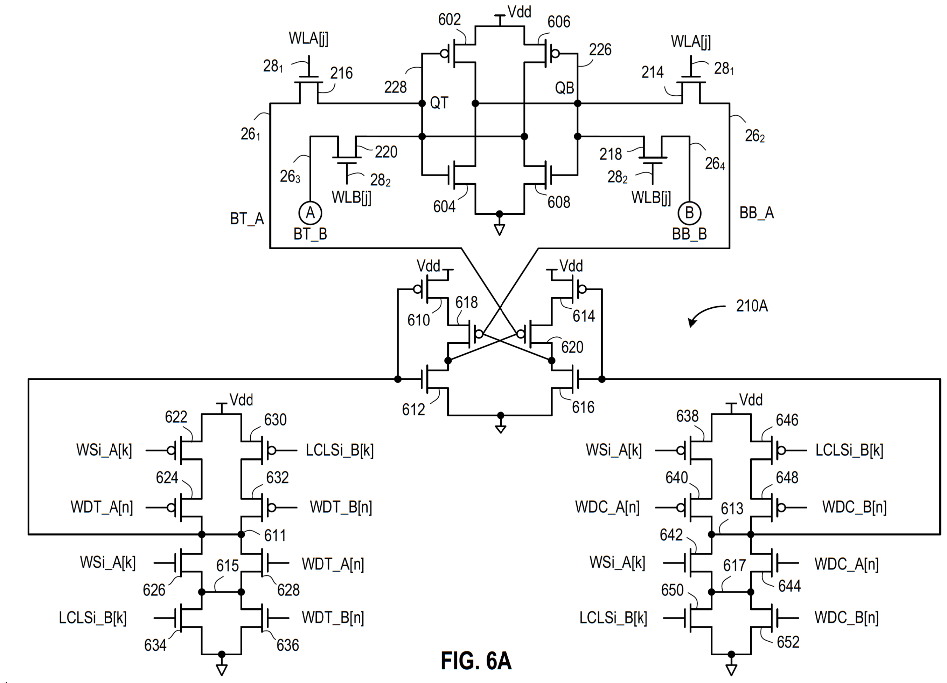

Figs. 6A-6B show a schematic diagram depicting write drivers 210A and 210B, coupled to memory cell 10, of Fig. 2 according to some embodiments. Elements of Figs. 6A-6B that are the same as in Fig. 2 are designated with identical reference numerals. As shown in Fig. 6A, inverter 222 can include a PMOS transistor 606 and an NMOS transistor 608. Inverter 224 can include a PMOS transistor 602 and an NMOS transistor 604. The sources of PMOS transistors 602 and 606 can be coupled to a supply voltage (Vdd). The drain of PMOS transistor 602 can be coupled to node 226 and the drain of PMOS transistor 606 can be coupled to node 228. The gate of PMOS transistor 602 can be coupled to node 228 and the gate of PMOS transistor 606 can be coupled to node 226. The sources of NMOS transistors 604 and 608 can be coupled to electrical ground. The drain of NMOS transistor 604 can be coupled to node 226 and the drain of NMOS transistor 608 can be coupled to node 228. The gate of NMOS transistor 604 can be coupled to node 228 and the gate of NMOS transistor 608 can be coupled to node 226. The supply voltage Vdd can be supplied by a voltage supply circuit of controller 16. Electrical ground may be a reference voltage (e.g., 0 V) for other voltages in controller 16, including Vdd. A voltage at or near Vdd can represent logic 1 and a voltage at or near electrical ground can represent a logic 0.

Write driver 210A can include a first CMOS circuit comprising PMOS transistors 610, 614, 618, and 620, and NMOS transistors 612 and 616. The sources of PMOS transistors 610 and 614 can be coupled to the supply voltage (Vdd). The drain of PMOS transistor 610 can be coupled to the source of PMOS transistor 618. The drain of PMOS transistor 618 can be coupled to the drain of NMOS transistor 612. The drain of PMOS transistor 614 can be coupled to the source of PMOS transistor 620. The drain of PMOS transistor 620 can be coupled to the drain of NMOS transistor 616. The sources of NMOS transistors 612 and 616 can be coupled to the electrical ground. The gates of PMOS transistor 610 and NMOS transistor 612 can be coupled to a node 611. The gates of PMOS transistor 614 and NMOS transistor 616 can be coupled to a node 613. The gate of PMOS transistor 618, and the drains of PMOS transistor 620 and NMOS transistor 616, can be coupled to node 26₂ (BB_A). The gate of PMOS transistor 620, and the drains of PMOS transistor 618 and NMOS transistor 612, can be coupled to node 26₁ (BT_A).

Write driver 210A can include a second CMOS circuit comprising PMOS transistors 622, 624, 630, and 632, and NMOS transistors 626, 628, 634, and 636. The sources of PMOS transistors 622 and 630 can be coupled to the supply voltage (Vdd). The drain of PMOS transistor 622 can be coupled to the source of PMOS transistor 624. The drain of PMOS transistor 624 can be coupled to node 611. The drain of PMOS transistor 630 can be coupled to the source of PMOS transistor 632. The drain of PMOS transistor 632 can be coupled to node 611. The drain of NMOS transistor 626 can be coupled to node 611. The source of NMOS transistor 626 can be coupled to a node 615. The drain of NMOS transistor 634 can be coupled to node 615. The drain of NMOS transistor 628 can be coupled to node 611. The source of NMOS transistor 628 can be coupled to node 615. The drain of NMOS transistor 636 can be coupled to node 615. The sources of NMOS transistors 634 and 636 can be coupled to the electrical ground.

Write driver 210A can include a third CMOS circuit comprising PMOS transistors 638, 640, 646, and 648, and NMOS transistors 642, 644, 650, and 652. The sources of PMOS transistors 638 and 646 can be coupled to the supply voltage (Vdd). The drain of PMOS transistor 638 can be coupled to the source of PMOS transistor 640. The drain of PMOS transistor 640 can be coupled to node 613. The drain of PMOS transistor 646 can be coupled to the source of PMOS transistor 648. The drain of PMOS transistor 648 can be coupled to node 613. The drain of NMOS transistor 642 can be coupled to node 613. The source of NMOS transistor 642 can be coupled to a node 617. The drain of NMOS transistor 650 can be coupled to node 617. The drain of NMOS transistor 644 can be coupled to node 613. The source of NMOS transistor 644 can be coupled to node 617. The drain of NMOS transistor 652 can be coupled to node 617. The sources of NMOS transistors 650 and 652 can be coupled to the electrical ground.

The gates of PMOS transistors 622 and 638, and the gates of NMOS transistors 626 and 642, can receive the logic signal WSi_A[k]. The gates of PMOS transistor 624 and NMOS transistor 628 can receive the logic signal WDT_A[n]. The gates of PMOS transistor 640 and NMOS transistor 644 can receive the logic signal WDC_A[n]. The gates of PMOS transistors 630 and 646, and the gates of NMOS transistors 634 and 650, can receive the logic signal LCLSi_B[k]. The gates of PMOS transistor 632 and NMOS transistor 636 can receive the logic signal WDT_B[n]. The gates of PMOS transistor 648 and NMOS transistor 652 can receive the logic signal WDC_B[n].

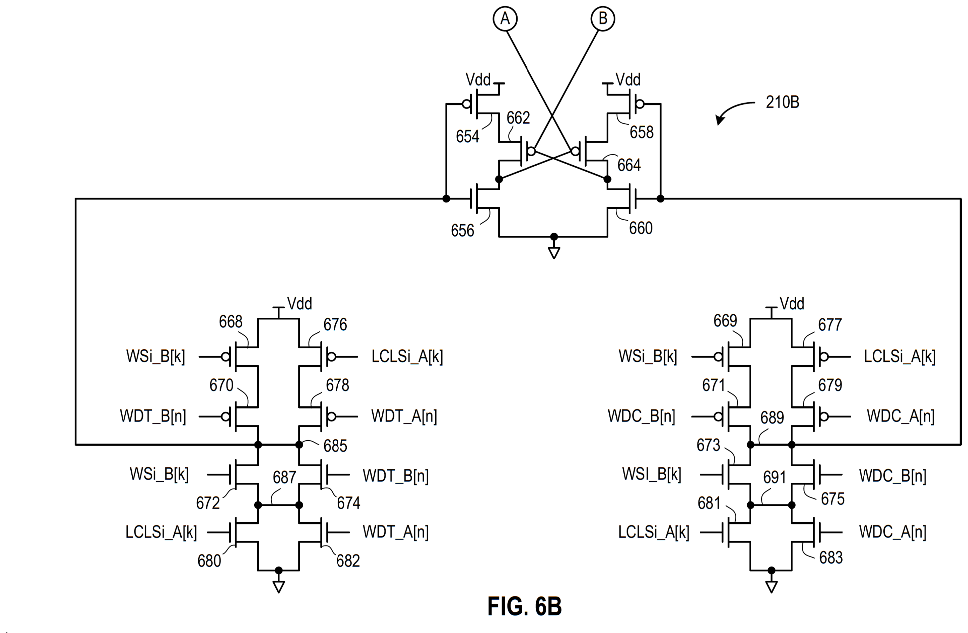

As shown in Fig. 6B, write driver 210B can include a first CMOS circuit comprising PMOS transistors 654, 658, 662, and 664, and NMOS transistors 656 and 660. The sources of PMOS transistors 654 and 658 can be coupled to the supply voltage (Vdd). The drain of PMOS transistor 654 can be coupled to the source of PMOS transistor 662. The drain of PMOS transistor 662 can be coupled to the drain of NMOS transistor 656. The drain of PMOS transistor 658 can be coupled to the source of PMOS transistor 664. The drain of PMOS transistor 664 can be coupled to the drain of NMOS transistor 660. The sources of NMOS transistors 656 and 660 can be coupled to the electrical ground. The gates of PMOS transistor 654 and NMOS transistor 656 can be coupled to a node 685. The gates of PMOS transistor 658 and NMOS transistor 660 can be coupled to a node 689. The gate of PMOS transistor 662, and the drains of PMOS transistor 664 and NMOS transistor 660, can be coupled to node 26₄ (BB_B). The gate of PMOS transistor 664, and the drains of PMOS transistor 662 and NMOS transistor 656, can be coupled to node 26₃ (BT_B).

Write driver 210B can include a second CMOS circuit comprising PMOS transistors 668, 670, 676, and 678, and NMOS transistors 672, 674, 680, and 682. The sources of PMOS transistors 668 and 676 can be coupled to the supply voltage (Vdd). The drain of PMOS transistor 668 can be coupled to the source of PMOS transistor 670. The drain of PMOS transistor 670 can be coupled to node 685. The drain of PMOS transistor 676 can be coupled to the source of PMOS transistor 678. The drain of PMOS transistor 678 can be coupled to node 685. The drain of NMOS transistor 672 can be coupled to node 685. The source of NMOS transistor 672 can be coupled to a node 687. The drain of NMOS transistor 680 can be coupled to node 687. The drain of NMOS transistor 674 can be coupled to node 685. The source of NMOS transistor 674 can be coupled to node 687. The drain of NMOS transistor 682 can be coupled to node 687. The sources of NMOS transistors 680 and 682 can be coupled to the electrical ground.

Write driver 210B can include a third CMOS circuit comprising PMOS transistors 669, 671, 677, and 679, and NMOS transistors 673, 675, 681, and 683. The sources of PMOS transistors 669 and 667 can be coupled to the supply voltage (Vdd). The drain of PMOS transistor 669 can be coupled to the source of PMOS transistor 671. The drain of PMOS transistor 671 can be coupled to node 689. The drain of PMOS transistor 677 can be coupled to the source of PMOS transistor 679. The drain of PMOS transistor 679 can be coupled to node 689. The drain of NMOS transistor 673 can be coupled to node 689. The source of NMOS transistor 673 can be coupled to a node 691. The drain of NMOS transistor 681 can be coupled to node 691. The drain of NMOS transistor 675 can be coupled to node 689. The source of NMOS transistor 675 can be coupled to node 691. The drain of NMOS transistor 683 can be coupled to node 691. The sources of NMOS transistors 681 and 683 can be coupled to the electrical ground.

The gates of PMOS transistors 668 and 669, and the gates of NMOS transistors 672 and 673, can receive the logic signal WSi_B[k]. The gates of PMOS transistor 670 and NMOS transistor 674 can receive the logic signal WDT_B[n]. The gates of PMOS transistor 671 and NMOS transistor 675 can receive the logic signal WDC_B[n]. The gates of PMOS transistors 676 and 677, and the gates of NMOS transistors 680 and 681, can receive the logic signal LCLSi_A[k]. The gates of PMOS transistor 678 and NMOS transistor 682 can receive the logic signal WDT_A[n]. The gates of PMOS transistor 679 and NMOS transistor 683 can receive the logic signal WDC_A[n].

The second CMOS circuit of write driver 210A can implement a Boolean function of: (WSi_A[k] NOR WDT_A[n]) OR (LCLSi_B[k] NOR WDT_B[n]), the output of which is coupled to node 611. The third CMOS circuit of write driver 210A can implement a Boolean function of: (WSi_A[k] NOR WDC_A[n]) OR (LCLSi_B[k] NOR WDC_B[n]), the output of which is coupled to node 613. The second CMOS circuit of write driver 210B can implement a Boolean function of: (WSi_B[k] NOR WDT_B[n]) OR (LCLSi_A[k] NOR WDT_A[n]), the output of which is coupled to node 685. The third CMOS circuit of write driver 210B can implement a Boolean function of: (WSi_B[k] NOR WDC_B[n]) OR (LCLSi_A[k] NOR WDC_A[n]), the output of which is coupled to node 689.

In operation, consider the example as shown in Fig. 3A. Assume the write on port A, and the read on port B, address the same word in the jth row of the ith bank. Assume further that the kth selector bit 20 of add_A is set to logic 1 (enabling write of sub-word 32ₖ). Assume further that Figs. 2, 6A, and 6B show the write drivers 210A and 210B for a bit in the sub-word 32ₖ corresponding to the nth bit position of din_A and dout_B. Assume that din_A[n] is logic 0. Finally, assume that before the write on port A, QT is logic 1 (e.g., memory cell 10 stores logic 1). In such an example:
1) WDT_A[n] is logic 0 and WDC_A[n] is logic 1;
2) WSi_A[k] is logic 0 and WSi_B[k] is logic 1;
3) LCLSi_B[k] is logic 1 and LCLSi_A[k] is logic 0.
This results in the following operation of write driver 210A:
1) PMOS transistors 622 and 624 are on and NMOS transistors 626 and 628 are off, charging node 611 to supply or logic 1;
2) PMOS transistors 646 and 640 are off and NMOS transistors 644 and 650 are on, discharging node 613 to electrical ground or logic 0;
3) NMOS transistor 612 is on, discharging BT_A, and PMOS transistors 614 and 620 are on, charging BB_A.
This results in the following operation of write driver 210B:
1) PMOS transistors 676 and 678 are on and NMOS transistors 680 and 682 are off, charging node 685 to supply or logic 1;
2) PMOS transistors 679 and 669 are off and NMOS transistors 683 and 673 are on, discharging node 689 to electrical ground or logic 0;
3) NMOS transistor 656 is on, discharging BT_B, and PMOS transistors 658 and 664 are on, charging BB_B.
This results in the following operation of memory cell 10:
1) WLA[j] and WLB[j] are logic 1, turning on transistors 214, 216, 218, and 220;
2) BT_A (from write) and BT_B (from pseudo write) both discharging and coupled to node 228;
3) BB_A (from write), BB_B (from pseudo write), and precharge 310B all charging and coupled to node 226;
4) QT changes from logic 1 to logic 0; QB changes from logic 0 to logic 1.

Since BT_B is discharging due to charge sharing mitigation, there is no bounce at node 228 from precharge 310B and write ability can be improved. A similar set of operations can occur when the write on port A changes the state of memory cell 10 from logic 0 to logic 1. In that case, BB_B can be discharging due to charge sharing mitigation, mitigating bounce at node 226 from precharge 310B and improving write ability. A similar set of operations can occur in the example of Fig. 3C, where the read operation on port B occurs prior to the write operation on port A. In those cases, it is the retained charge from the read that is mitigated rather than the precharge.

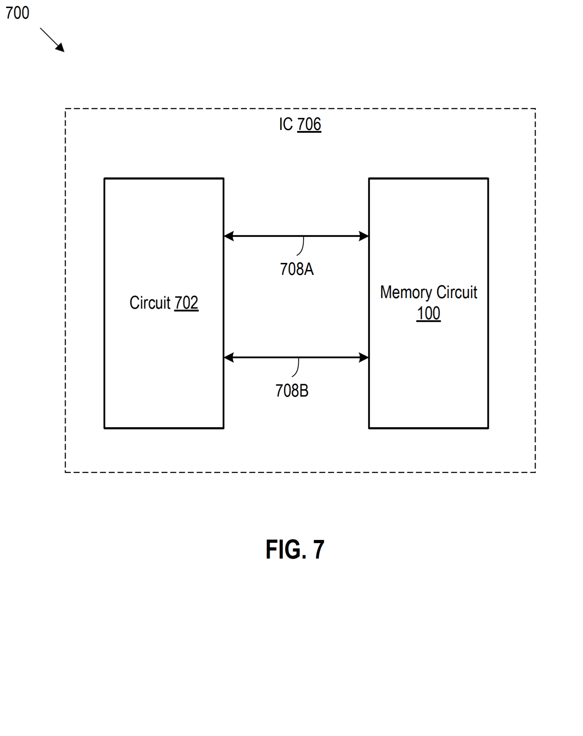

Fig. 7 is a block diagram depicting a circuit 700 according to some embodiments. Circuit 700 can include a circuit 702 coupled to memory circuit 100. Circuit 702 can include a connection 708A to port 18A of memory circuit 100 (e.g., a bus) and a connection 708B to port 18B of memory circuit 100 (e.g., another bus). In some embodiments, circuit 702 and memory circuit 100 can be part of an integrated circuit (IC) 706. An IC may be a circuit formed on a semiconductor substrate. In other embodiments, circuit 702 and memory circuit 100 can be separate ICs. Circuit 702 can supply signals to port 18A of memory circuit 100 via connection 707A. Circuit 702 can supply signals to port 18B of memory circuit 100 via connection 708B. In some embodiments, circuit 702 can supply signals to port 18A to write to memory cells (e.g., addressed memory cells) and supply signals to port 18B to read from the same memory cells. Conversely, circuit 702 can supply signals to port 18B to write to memory cells and supply signals to port 18A to read from the same memory cells.

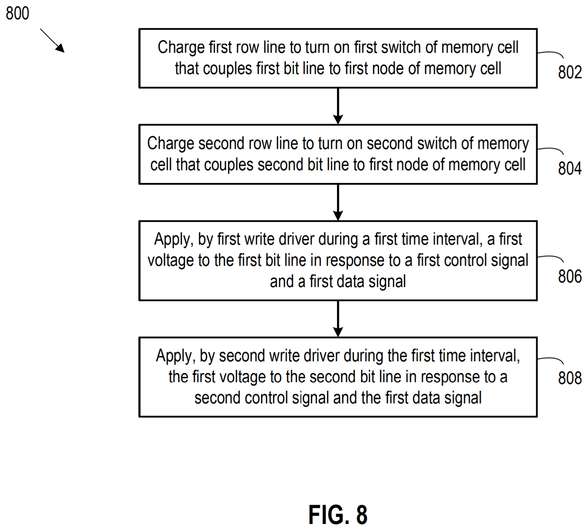

Fig. 8 is a flow diagram depicting a method 800 of driving a memory cell in a dual-port memory circuit according to embodiments. Method 800 can begin at step 802, where controller 16 can charge a first row line (e.g., 28₁) to turn on a first switch (e.g., transistor 216) of memory cell 10 that couples a first bit line (e.g., BT_A) to a first node (e.g., node 228) of memory cell 10. At step 804, controller 16 can charge a second row line (e.g., 28₂) to turn on a second switch (e.g., transistor 220) of memory cell 10 that couples a second bit line (e.g., BT_B) to the first node (e.g., node 228) of memory cell 10. At step 806, controller 16 can apply, using a first write driver (e.g., write driver 210A) during a first time interval, a first voltage to the first bit line in response to a first control signal (e.g., WSi_A[k]) and a first data signal (e.g., WDT_A[n]). At step 808, controller 16 can apply, using a second write driver (e.g., write driver 210B) during the first time interval, the first voltage to the second bit line in response to a second control signal (e.g., LCLSi_A[k]) and the first data signal (e.g., WDT_A[n]).

While some processes and methods having various operations have been described, one or more embodiments also relate to a device or an apparatus for performing these operations. The apparatus may be specially constructed for required purposes, or the apparatus may be a general-purpose computer selectively activated or configured by a computer program stored in the computer. Various general-purpose machines may be used with computer programs written in accordance with the teachings herein, or it may be more convenient to construct a more specialized apparatus to perform the required operations.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C ," or alternatively, "at least one of A, at least one of B, and at least one of C," it is expressly described as such.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

As used herein, the term "couple" and its derivatives include: (a) electrical, magnetic, and communicative coupling; and (b) do not imply a direct connection, but rather may include intervening elements, unless described as "directly coupled."

Although one or more embodiments of the present invention have been described in some detail for clarity of understanding, certain changes may be made within the scope of the claims. Accordingly, the described embodiments are to be considered as illustrative and not restrictive, and the scope of the claims is not to be limited to details given herein but may be modified within the scope and equivalents of the claims. In the claims, elements and/or steps do not imply any particular order of operation unless explicitly stated in the claims.

Boundaries between components, operations, and data stores are somewhat arbitrary, and particular operations are illustrated in the context of specific illustrative configurations. Other allocations of functionality are envisioned and may fall within the scope of the invention. In general, structures and functionalities presented as separate components in exemplary configurations may be implemented as a combined structure or component. Similarly, structures and functionalities presented as a single component may be implemented as separate components. These and other variations, additions, and improvements may fall within the scope of the appended claims.

The invention further provides the following embodiments:
1. A memory circuit, comprising:
   a memory cell coupled to a first row line, a second row line, a first bit line, and a second bit line, the first bit line and the second bit line coupled to a first node of the memory cell, the memory cell configured to store a bit; and
   a controller including a first write driver coupled to the first bit line and a second write driver coupled to the second bit line, the first write driver configured to, during a first time interval, apply a first voltage to the first bit line in response to a first control signal and a first data signal, the second write driver configured to, during the first time interval, apply the first voltage to the second bit line in response to a second control signal and the first data signal.
2. The memory circuit of embodiment 1, wherein the controller is configured to charge the first row line to turn on a first switch of the memory cell and electrically connect the first bit line to the first node, and charge the second row line to turn on a second switch of the memory cell and electrically connect the second bit line to the first node.
3. The memory circuit of embodiment 1, wherein the controller is coupled to a supply voltage representing logic 1 and an electrical ground representing logic 0, wherein prior to the first time interval a state of the bit is logic 1, wherein a state of the first data signal is logic 0, wherein the first voltage is electrical ground, and wherein the first write driver is configured to, during the first time interval, control a first switch to electrically connect the electrical ground to the first bit line.
4. The memory circuit of embodiment 3, wherein the controller includes a precharge circuit configured to apply the supply voltage to the second bit line during first time interval, and wherein the second write driver is configured to, during the first time interval, control a second switch to electrically connect the electrical ground to the second bit line.
5. The memory circuit of embodiment 3, wherein the controller includes a precharge circuit configured to charge the second bit line prior to the first time interval, and wherein the second write driver is configured to, during the first time interval, control a second switch to electrically connect the electrical ground to the second bit line.
6. The memory circuit of embodiment 1, wherein the controller includes a first port and a second port, wherein the first port is configured to receive first signals to write to the memory cell, and wherein the second port is configured to receive second signals to read from the memory cell.
7. The memory circuit of embodiment 6, wherein the controller is configured to derive the first control signal and the first data signal from the first signals, and wherein the controller includes first combinational logic configured to generate the second control signal in response to detecting a condition of the first port writing to, and the second port reading from, the memory cell during the first time interval.
8. The memory circuit of embodiment 1, wherein the first write driver includes a first complementary metal-oxide semiconductor (CMOS) circuit coupled to the first bit line and a second CMOS circuit coupled to a second node of the first CMOS circuit, and wherein the second write driver includes a third CMOS circuit coupled to the second bit line and a fourth CMOS circuit coupled to a third node of the third CMOS circuit.
9. The memory circuit of embodiment 8, wherein the second CMOS circuit is configured to drive the second node with a logical combination of the first control signal and the first data signal, and wherein the fourth CMOS circuit is configured to drive the third node with a logical combination of the second control signal and the first data signal.
10. The memory circuit of embodiment 9, wherein the second node includes a gate of a first n-type metal-oxide semiconductor (NMOS) transistor of the first CMOS circuit, wherein the third node include includes a gate of a second NMOS transistor of the third CMOS circuit, wherein a source of the first NMOS transistor is coupled to electrical ground and a drain of the first NMOS transistor is coupled to the first bit line, and wherein a source of the second NMOS transistor is coupled to the electrical ground and a drain of the second NMOS transistor is coupled to the second bit line.
11. An apparatus, comprising:
   a memory circuit including a first port and a second port; and
   a first circuit coupled to the memory circuit via the first port and the second port, the first circuit configured to supply first signals to the first port to write to a memory cell of the memory circuit and second signals to the second port to read from the memory cell;
   wherein the memory cell is coupled to a first bit line and a second bit line, the first bit line and the second bit line coupled to a first node of the memory cell;
   wherein the memory circuit includes a controller, the controller comprising a first write driver coupled to the first bit line and a second write driver coupled to the second bit line, the first write driver configured to, during a first time interval, apply a first voltage to the first bit line in response to a first control signal and a first data signal, the second write driver configured to, during the first time interval, apply the first voltage to the second bit line in response to a second control signal and the first data signal.
12. The apparatus of embodiment 11, wherein the controller is configured to derive the first control signal and the first data signal from the first signals.
13. The apparatus of embodiment 12, wherein the controller includes first combinational logic configured to generate the second control signal in response to detecting a condition of the first port writing to, and the second port reading from, the memory cell during the first time interval.
14. The apparatus of embodiment 11, wherein the controller includes a precharge circuit configured to apply a supply voltage to the second bit line during the first time interval, wherein the first voltage is electrical ground, and wherein the second write driver is configured to, during the first time interval, control a first switch to couple the electrical ground to the second bit line.
15. The apparatus of embodiment 11, wherein the controller includes a precharge circuit configured to charge the second bit line prior to the first time interval, wherein the first voltage is electrical ground, and wherein the second write driver is configured to, during the first time interval, control a first switch to couple the electrical ground to the second bit line.
16. The apparatus of embodiment 11, wherein the memory cell comprises a first inverter and a second inverter, an input of the first inverter coupled to an output of the second inverter and an input of the second inverter coupled to an output of the first inverter, and wherein the first node of the memory cell includes the input of the first inverter and the output of the second inverter.
17. A method of driving a memory cell in a dual-port memory circuit, comprising:
   charging a first row line to turn on a first switch of the memory cell that couples a first bit line to a first node of the memory cell;
   charging a second row line to turn on a second switch of the memory cell that couples a second bit line to the first node;
   applying, by a first write driver during a first time interval, a first voltage to the first bit line in response to a first control signal and a first data signal; and
   applying, by a second write driver during the first time interval, the first voltage to the second bit line in response to a second control signal and the first data signal.
18. The method of embodiment 17, wherein the memory cell stores a bit, wherein prior to the first time interval a state of the bit is logic 1, wherein a state of the first data signal is logic 0, wherein the first voltage is an electrical ground, and wherein the step of applying by the first write driver includes controlling, during the first time interval, a third switch to couple the electrical ground to the first bit line.
19. The method of embodiment 18, further comprising:
   applying, by a precharge circuit during the first time interval, a supply voltage to the second bit line;
   wherein the step of applying by the second write driver includes controlling, during the first time interval, a fourth switch to couple the electrical ground to the second bit line.
20. The method of embodiment 18, further comprising:
   applying, by a precharge circuit prior to the first time interval, a supply voltage to the second bit line;
   wherein the step of applying by the second write driver includes controlling, during the first time interval, a fourth switch to couple the electrical ground to the second bit line.

## Claims

1. A memory circuit, comprising:
a memory cell coupled to a first row line, a second row line, a first bit line, and a second bit line, the first bit line and the second bit line coupled to a first node of the memory cell, the memory cell configured to store a bit; and
a controller including a first write driver coupled to the first bit line and a second write driver coupled to the second bit line, the first write driver configured to, during a first time interval, apply a first voltage to the first bit line in response to a first control signal and a first data signal, the second write driver configured to, during the first time interval, apply the first voltage to the second bit line in response to a second control signal and the first data signal.

2. The memory circuit of claim 1, wherein the controller is configured to charge the first row line to turn on a first switch of the memory cell and electrically connect the first bit line to the first node, and charge the second row line to turn on a second switch of the memory cell and electrically connect the second bit line to the first node.

3. The memory circuit of claim 1, wherein the controller is coupled to a supply voltage representing logic 1 and an electrical ground representing logic 0, wherein prior to the first time interval a state of the bit is logic 1, wherein a state of the first data signal is logic 0, wherein the first voltage is electrical ground, and wherein the first write driver is configured to, during the first time interval, control a first switch to electrically connect the electrical ground to the first bit line.

4. The memory circuit of claim 3, wherein the controller includes a precharge circuit configured to apply the supply voltage to the second bit line during first time interval, and wherein the second write driver is configured to, during the first time interval, control a second switch to electrically connect the electrical ground to the second bit line,
and/or wherein the controller includes a precharge circuit configured to charge the second bit line prior to the first time interval, and wherein the second write driver is configured to, during the first time interval, control a second switch to electrically connect the electrical ground to the second bit line.

5. The memory circuit of claim 1, wherein the controller includes a first port and a second port, wherein the first port is configured to receive first signals to write to the memory cell, and wherein the second port is configured to receive second signals to read from the memory cell,
in particular
wherein the controller is configured to derive the first control signal and the first data signal from the first signals, and wherein the controller includes first combinational logic configured to generate the second control signal in response to detecting a condition of the first port writing to, and the second port reading from, the memory cell during the first time interval.

6. The memory circuit of claim 1, wherein the first write driver includes a first complementary metal-oxide semiconductor (CMOS) circuit coupled to the first bit line and a second CMOS circuit coupled to a second node of the first CMOS circuit, and wherein the second write driver includes a third CMOS circuit coupled to the second bit line and a fourth CMOS circuit coupled to a third node of the third CMOS circuit.

7. The memory circuit of claim 6, wherein the second CMOS circuit is configured to drive the second node with a logical combination of the first control signal and the first data signal, and wherein the fourth CMOS circuit is configured to drive the third node with a logical combination of the second control signal and the first data signal,
in particular
wherein the second node includes a gate of a first n-type metal-oxide semiconductor (NMOS) transistor of the first CMOS circuit, wherein the third node include includes a gate of a second NMOS transistor of the third CMOS circuit, wherein a source of the first NMOS transistor is coupled to electrical ground and a drain of the first NMOS transistor is coupled to the first bit line, and wherein a source of the second NMOS transistor is coupled to the electrical ground and a drain of the second NMOS transistor is coupled to the second bit line.

8. An apparatus, comprising:
a memory circuit including a first port and a second port; and
a first circuit coupled to the memory circuit via the first port and the second port, the first circuit configured to supply first signals to the first port to write to a memory cell of the memory circuit and second signals to the second port to read from the memory cell;
wherein the memory cell is coupled to a first bit line and a second bit line, the first bit line and the second bit line coupled to a first node of the memory cell;
wherein the memory circuit includes a controller, the controller comprising a first write driver coupled to the first bit line and a second write driver coupled to the second bit line, the first write driver configured to, during a first time interval, apply a first voltage to the first bit line in response to a first control signal and a first data signal, the second write driver configured to, during the first time interval, apply the first voltage to the second bit line in response to a second control signal and the first data signal.

9. The apparatus of claim 8, wherein the controller is configured to derive the first control signal and the first data signal from the first signals,
in particular
wherein the controller includes first combinational logic configured to generate the second control signal in response to detecting a condition of the first port writing to, and the second port reading from, the memory cell during the first time interval.

10. The apparatus of claim 8, wherein the controller includes a precharge circuit configured to apply a supply voltage to the second bit line during the first time interval, wherein the first voltage is electrical ground, and wherein the second write driver is configured to, during the first time interval, control a first switch to couple the electrical ground to the second bit line.

11. The apparatus of claim 8, wherein the controller includes a precharge circuit configured to charge the second bit line prior to the first time interval, wherein the first voltage is electrical ground, and wherein the second write driver is configured to, during the first time interval, control a first switch to couple the electrical ground to the second bit line.

12. The apparatus of claim 8, wherein the memory cell comprises a first inverter and a second inverter, an input of the first inverter coupled to an output of the second inverter and an input of the second inverter coupled to an output of the first inverter, and wherein the first node of the memory cell includes the input of the first inverter and the output of the second inverter.

13. A method of driving a memory cell in a dual-port memory circuit, comprising:
charging a first row line to turn on a first switch of the memory cell that couples a first bit line to a first node of the memory cell;
charging a second row line to turn on a second switch of the memory cell that couples a second bit line to the first node;
applying, by a first write driver during a first time interval, a first voltage to the first bit line in response to a first control signal and a first data signal; and
applying, by a second write driver during the first time interval, the first voltage to the second bit line in response to a second control signal and the first data signal.

14. The method of claim 13, wherein the memory cell stores a bit, wherein prior to the first time interval a state of the bit is logic 1, wherein a state of the first data signal is logic 0, wherein the first voltage is an electrical ground, and wherein the step of applying by the first write driver includes controlling, during the first time interval, a third switch to couple the electrical ground to the first bit line.

15. The method of claim 14, further comprising:
applying, by a precharge circuit during the first time interval, a supply voltage to the second bit line;
wherein the step of applying by the second write driver includes controlling, during the first time interval, a fourth switch to couple the electrical ground to the second bit line,
and/or further comprising:
applying, by a precharge circuit prior to the first time interval, a supply voltage to the second bit line;
wherein the step of applying by the second write driver includes controlling, during the first time interval, a fourth switch to couple the electrical ground to the second bit line.
